# EUROPÄISCHE PATENTSCHRIFT

(11) **EP 0 879 479 B1**
(45) Veröffentlichungstag und Bekanntmachung des Hinweises auf die Patenterteilung: **02.05.2003**
(21) Anmeldenummer: 97914128.0
(22) Anmeldetag: 06.02.1997
(51) Int. Cl.: H01L 23/535, H01L 27/02

(54) **AUFTRENNBARE VERBINDUNGSBRÜCKE (FUSE) UND VERBINDBARE LEITUNGSUNTERBRECHUNG (ANTI-FUSE), SOWIE VERFAHREN ZUR HERSTELLUNG UND AKTIVIERUNG EINER FUSE UND EINER ANTI-FUSE**
SEPARABLE CONNECTING BRIDGE (FUSE) AND CONNECTABLE LINE INTERRUPTION (ANTI-FUSE) AND PROCESS FOR PRODUCING AND ACTIVATING A FUSE AND AN ANTI-FUSE
PONT DE CONNEXION SEPARABLE (FUSIBLE) ET COUPURE DE LIGNE CONNECTABLE (ANTIFUSIBLE), ET PROCEDE POUR L'OBTENTION ET L'ACTIVATION D'UN FUSIBLE ET D'UN ANTIFUSIBLE

(30) Priorität: 09.02.1996 DE 19604776
(43) Veröffentlichungstag der Anmeldung: 25.11.1998
(73) Patentinhaber: Infineon Technologies AG, 81669 München (DE)
(72) Erfinder: ZETTLER, Thomas, D-81737 München (DE); WINNERL, Josef, D-81929 München (DE); GEORGAKOS, Georg, D-85447 Fraunberg (DE); POCKRANDT, Wolfgang, D-85293 Reichertshausen (DE)
(74) Vertreter: Epping Hermann & Fischer
(86) Internationale Anmeldenummer: DE9700235
(87) Internationale Veröffentlichungsnummer: WO97029515

(56) Entgegenhaltungen:
- EP-A- 0 054 102
- EP-A- 0 330 299
- EP-A- 0 655 783
- GB-A- 2 056 771
- GB-A- 2 100 057
- DATABASE WPI Section EI, Week 9540 Derwent Publications Ltd., London, GB; Class U11, AN 95-310140 XP002034866 ANONYMOUS: "Fuse links for I.C. - with elimination of doped semiconductor region in substrate beneath fuse links" & RESEARCH DISCLOSURE, Bd. 376, Nr. 012, 10.August 1995, EMSWORTH, GB,
- IBM TECHNICAL DISCLOSURE BULLETIN, Bd. 21, Nr. 3, August 1978, NEW YORK, Seite 1086 XP002034865 K. BRACK ET AL.: "directed activation of implanted semiconductor zones"

## Beschreibung

Die Erfindung bezieht sich auf eine auftrennbare Verbindungsbrücke und eine verbindbare Leitungsunterbrechung, sowie auf ein Verfahren zur Herstellung und Aktivierung einer auftrennbaren Verbindungsbrücke und einer verbindbaren Leitungsunterbrechung.

Fuse-Anordnungen werden in integrierten Schaltungen eingesetzt, um nach dem eigentlichen Fertigungsprozeß elektrisch leitfähige Verbindungen aufzutrennen ("Fuse") oder neu herzustellen ("Anti-Fuse"). Die Anwendungen derartiger Fuse-Anordnungen sind sehr vielfältig. So werden Fuses zum Trimmen, beispielsweise von analogen Schaltungen verwendet. Weiterhin werden Fuses verwendet, um redundante Schaltungsteile zu aktivieren und fehlerhafte abzuschalten. In programmierbaren Logik-Arrays (PLA) werden durch Fuses die logischen Verknüpfungen programmiert. In sicherheitskritischen Schaltungen wird durch Fuses der Zugriff auf Testmodi der Schaltung für Unbefugte verhindert.

Wesentliche Kriterien für Fuse- bzw. Anti-Fuseanordnungen sind Lebensdauer und Zuverlässigkeit, d.h. wie sicher und über welchen Zeitraum eine Fuse bzw. Anti-Fuse die beiden Zustände Aus/Ein konserviert, und zwar unabhängig von Stromdichte und Temperatur. Ein weiteres Kriterium ist der Aufwand zur Aktivierung von Fuse-bzw. Anti-Fuseanordnungen, beispielsweise beim Testen einer Fuse. Für sicherheitskritische Anwendungen ist weiterhin die Sicherheit vor Umprogrammierung und externer Kontaktierung wesentlich.

Bisher wurden im wesentlichen Fuse-Anordnungen aus Metall, aus Polysilizium, oder aus einem Dielektrikum gefertigt.

Bei den zuerst genannten Fuse-Anordnungen sind solche aus dem Material der Metallisierungsebenen (beispielsweise AlSiCu) gefertigte Fuses weit verbreitet für Trimm- und Sicherheitsanwendungen. Man unterscheidet nach Art der Aktivierung Laserfuses und elektrische Fuses. Bei Laserfuses wird durch die Energie eines gepulsten Lasers (beispielsweise Neodym YAG-Laser) die Metallbahn der Fuse-Anordnung lokal, d.h. in einer typischen Breite von 2 bis etwa 5 µm aufgeschmolzen und auf diese Weise unterbrochen. Die Laserfuse-Anordnung besitzt den Nachteil einer relativ langen Wafer-Gesamtbearbeitung bei höheren Kosten für den Tester mit Lasereinheit. Elektrische Fuse-Anordnungen werden demgegenüber durch einen ausreichend hohen Stromimpuls aufgetrennt. Bei höheren Betriebstemperaturen besteht bei allen Metall-Fuse-Anordnungen die Gefahr des erneuten Zusammenwachsens. Weiterhin sind Metall-Fuses relativ leicht von außen durch optische Hilfsmittel aufzufinden und durch externe Kontaktierung zu manipulieren. Dies stellt insbesondere bei sicherheitsrelevanten Anwendungen einen erheblichen Nachteil dar.

Die einer weiteren Klasse zuzuordnenden Poly-Fuses werden in gleicher Art wie Metall-Fuses als Laserfuses oder elektrische Fuses ausgeführt. Als elektrische Fuse weist das leitfähige Material Poly-Silizium gegenüber Metall Nachteile auf, da durch die relativ gute thermische Ankopplung zum Substrat und die bessere Migrationsfestigkeit die thermische Zerstörung und damit die Aktivierung der Fuse schwieriger ist.

Die einer dritten Klasse zuzuordnenden Anti-Fuses mit einem Dielektrikum (beispielsweise aus dem Material SiN, vgl. M. T. Takagi, I. Yoshii, N. Ikeda, H. Yasuda, K. Hama, Pros. IEDM 1993, Seiten 31 bis bis 34) oder einem hochohmigen Halbleiter (beispielsweise aus amorphem Silizium, vgl. K. E. Gordon, R. J. Wong, Proc. IEDM 1993, Seiten 27 bis 30) als zerstörbarem Isolator werden typischerweise bei programmierbaren Logikarrays eingesetzt. Sie werden durch ausreichend hohe Spannungen aktiviert. Der Schutz gegen Manipulation ist gegenüber Metall- und Polyfuses verbessert. Dennoch besteht durch die lokal hohen Stromdichten in den programmierten (leitfähigen) Anti-Fuses die Gefahr des Wiederausheilens der Isolation. Ein weiterer wesentlicher Nachteil solcher Anti-Fuses ist der höhere Prozeßaufwand für die zusätzlichen Isolator- und Elektrodenschichten.

Aus der EP 655 783 A1 ist weiterhin eine Anti-Fuse-Anordnung mit einem innerhalb einer N-Wanne ausgebildeten P⁺-dotierten Diffusionsgebiet und einer dem Diffusionsgebiet zugeordneten Aluminiumleiterbahn bekannt geworden. Diese Anti-Fuse-Anordnung wird durch Beaufschlagen der Leiterbahn mit einem genügend großen Strom aktiviert, so daß Aluminium aus der Leiterbahn nach unten in das Diffusionsgebiet wandert, und durch Zerstörung des pn-Überganges des Diffusionsgebietes eine irreversible Leitung hervorgerufen wird. Diese Anti-Fuse-Anordnung stellt zunächst lediglich eine einseitige, d.h. lediglich in nur einer Stromrichtung betreibbare Anti-Fuse-Anordnung dar, d.h. sie wirkt als in Sperrichtung geschaltete Diode. Des weiteren ist zur Aktivierung der Anti-Fuse-Anordnung wie bei den gängigen Metallfuses eine Metallbahn erforderlich, die relativ leicht aufzufinden und durch externe Kontaktierung zu manipulieren ist, so daß eine derartige Anti-Fuse insbesondere bei sicherheitsrelevanten Anwendungen nicht einsetzbar ist. Schließlich ist es mit der aus der EP 655 783 A1 bekannten Anordnung grundsätzlich nicht möglich, Fuses auszubilden.

Der Erfindung liegt die Aufgabe zugrunde, eine einfach herzustellende und zu aktivierende Fuse- und/oder Anti-Fuse-Anordnung zur Verfügung zu stellen, welche in sicherheitsrelevanten integrierten Schaltungen angewendet werden kann.

Diese Aufgabe wird durch eine auftrennbare Verbindungsbrücke (Fuse) gemäß Anspruch 1, eine verbindbare Leitungsunterbrechung (Anti-Fuse) gemäß Anspruch 9, sowie durch ein Verfahren zur Herstellung und Aktivierung einer Fuse bzw. Anti-Fuse nach den Ansprüchen 15 und 17 gelöst.

Die Erfindung sieht die Ausbildung einer neuen Klasse bzw. eines neuen Typs von Fuse- und Anti-Fuseanordnungen vor, bei denen anstelle einer auf dem Substrat aufgebrachten und daher ohne weiteres erkennbaren Metallbahn eine innerhalb der Oberfläche des Halbleitersubstrates ausgebildete, von außen nicht erkennbare leitfähige Diffusionsbahn ausgebildet ist, die zur Aktivierung getrennt bzw. hergestellt wird. Das Halbleitermaterial des Substrats stellt einen ersten Leitungstyp dar, während das Material der Diffusionsverbindung von einem zweiten Leitungstyp ist, der vom ersten Leitungstyp entgegengesetztes Vorzeichen besitzt. In der nachfolgenden Beschreibung der Fuse- bzw. Anti-Fuseanordnungen mag der erste Leitungstyp als p und der zweite Leitungstyp als n bezeichnet sein, wobei es jedoch im Rahmen der Erfindung liegt, die beiden Leitungstypen zu vertauschen. Dem Prinzip der Erfindung folgend ist es möglich, Fuse- und Anti-Fuseanordnungen allein mit leitfähigen Diffusionsgebieten in einem Halbleitersubstrat auszubilden; jegliche Metallbahnen sind nicht erforderlich. Dadurch sind die erfindungsgemäßen Fuse- und Anti-Fuseanordnungen von außen nicht aufzufinden, eine externe Kontaktierung ist außerordentlich kompliziert, und eine Reprogrammierung unmöglich, so daß sich die erfindungsgemäßen Fuse- und Anti-Fuseanordnungen für Sicherheitsschaltungen hervorragend eignen. Die erfindungsgemäßen Fuse- und Anti-Fuseanordnungen besitzen eine inhärent hohe Zuverlässigkeit, da der zur Aktivierung der Fuse bzw. Anti-Fuse durchzuführende Diffusionsvorgang thermodynamisch irreversibel ist, so daß eine einmal aktivierte Fuse bzw. Anti-Fuse prinzipiell nicht wieder ausheilen kann.

Zur Aktivierung der Fuse- bzw. der Anti-Fuseanordnung gemäß Erfindung kann mit Vorteil ein Laserstrahl zur lokalen Aufheizung eines Aktivierungsabschnittes zum Einsatz kommen, wodurch eine irreversible, gegenseitige Ineinanderdiffusion der n- und p-Dopanden aus den Diffusionsgebieten erfolgt. Neben einer Erwärmung des Aktivierungsabschnittes durch den Einsatz eines Lasers ist grundsätzlich auch eine Erwärmung vermittels eines Stromflusses durch die Diffusionsbahn möglich. Ebenso sind andere Erwärmungsvarianten denkbar, beispielsweise in Form einer resistiven Heizung durch vorzugsweise aus Polysilizium gefertigte Widerstandsmäander, die in unmittelbarer Nachbarschaft zum Aktivierungsabschnitt integriert auf dem Halbleitersubstrat ausgebildet sein können.

Die erfindungsgemäße auftrennbare Verbindungsbrücke (Fuse) besitzt eine in einem aus Halbleitermaterial eines ersten Leitungstyps bestehenden Substrat ausgebildete elektrisch leitende, in Längserstreckung kontinuierlich durchgehende, quer zur Längserstreckung eine vorbestimmte Breite aufweisende Diffusions- bzw. Leitungsbahn eines zweiten, vom ersten Leitungstyp entgegengesetzten Leitungstyps, wobei das Halbleitermaterial des ersten Leitungstyps eine solche Konzentration gegenüber dem Material der Leitungsbahn aufweist, daß bei einer vorbestimmten Aktivierungstemperatur, die größer ist als die Betriebstemperatur der Verbindungsbrücke, über die gesamte Breite der Leitungsbahn eine Unterbrechung durch Diffusion des Dotierstoffes des Halbleitermaterials des ersten Leitungstyps erfolgt.

Hierbei kann vorgesehen sein, daß der Leitungsbahn ein in dem aus Halbleitermaterial bestehenden Substrat ausgebildeter Diffusionsbereich zugeordnet ist, der durch Dotierung mit einem Dotierstoff des ersten Leitungstyps ausgebildet ist.

Bei einer bevorzugten Ausführung der erfindungsgemäßen Verbindungsbrücke (Fuse) kann vorgesehen sein, daß der durch Dotierung mit dem Dotierstoff ausgebildete Diffusionsbereich des ersten Leitungstyps zu beiden Seiten der gegenüber den Abmessungen des Diffusionsbereiches eine geringere Breite besitzenden Leitungsbahn des zweiten Leitungstyps ausgebildet ist. Hierbei ist von Vorteil vorgesehen, daß die Leitungsbahn des zweiten Leitungstyps durch Dotierung mit einem Dotierelement ausgebildet ist, dessen Dotierkonzentration betragsmäßig kleiner als die Dotierkonzentration des Dotierstoffes des Diffusionsbereiches des ersten Leitungstyps ist.

Die erfindungsgemäße verbindbare Leitungsunterbrechung (Anti-Fuse) weist eine in einem aus Halbleitermaterial bestehenden Substrat ausgebildete elektrisch leitende, durch Dotierung mit einem Dotierstoff ausgebildete Diffusions- bzw. Leitungsbahn mit in Längserstreckung eine Lücke mit einem vorbestimmten Abstand bildende Leitungsbahnstücke eines ersten Leitungstyps und einem wenigstens den Bereich der Lücke der Leitungsbahnstücke ausfüllenden, Diffusionsbereich eines zweiten, vom ersten Leitungstyp entgegengesetzten Leitungstyps auf, wobei der Dotierstoff der Leitungsbahnstücke bei vorgegebener Diffusionskonstante bezüglich des Halbleitermaterials des Substrates eine solche Dotierkonzentration aufweist, daß bei einer vorbestimmten Aktivierungstemperatur, die größer ist als die Betriebstemperatur der Leitungsunterbrechung, über den gesamten Abstand der Lücke der Leiterbahn eine Diffusion des Dotierstoffes der Leitungsbahnstücke erfolgt und zu einer elektrischen Verbindung der beiden Leitungsbahn stücke führt.

Hierbei kann vorgesehen sein, daß der Diffusionsbereich des zweiten Leitungstyps durch Dotierung mit einem Dotierelement ausgebildet ist, dessen Dotierkonzentration betragsmäßig kleiner als die Dotierkonzentration des Dotierstoffes der Leitungsbahnstücke des ersten Leitungstyps ist.

Die erfindungsgemäße Leitungsunterbrechung (Anti-Fuse) zeichnet sich dadurch aus, daß durch die Leitungsbahnstücke und den die Lücke der Leitungsbahnstücke ausfüllenden Diffusionsbereich ein Aktivierungsabschnitt mit einem wenigstens zweimaligen p-n-Übergang ausgebildet ist. Damit stellt die Anti-Fuse gemäß Erfindung eine zweiseitige, echte Anti-Fuse in beiden Stromrichtungen dar.

Für Sicherheitsanwendungen vorteilhaft ist die praktisch unmögliche Analysierbarkeit und damit kaum durchzuführende externe Kontaktierbarkeit der erfindungsgemäßen Verbindungsbrücke, welche durch Passivierungsschichten geschützt bleibt. Hierbei kann vorgesehen sein, daß wenigstens der aus einem Teil der Leitungsbahn und dem Halbleitermaterial und/oder dem Diffusionsbereich bestehende Aktivierungsabschnitt mit einer auf der Hauptfläche des Substrates ausgebildeten elektrisch isolierenden, für Strahlung einer vorbestimmten Wellenlänge zur lokalen Erwärmung des Aktivierungsabschnittes transparenten oder wenigstens durchscheinenden Abdeckschicht überdeckt ist. Typische Fuse-Laser (beispielsweise Neodym YAG-Laser) durchdringen diese transparente oder wenigstes durchscheinende Abdeckschicht wie beispielsweise aus Oxid oder Si₃N₄ weitgehend ungehindert und deponieren die Strahlenergie vorwiegend in Silizium, also im Material der Diffusionsbahn oder des Substrates.

Als weitergehenden Vorteil für Sicherheitsanwendungen ermöglicht die Erfindung sogar, eine innerhalb des Halbleitersubstrats vergrabene Anordnung von Fuse bzw. Anti-Fuse vorzusehen, so daß eine Auffindung von außen und externe Kontaktierung noch schwieriger ist. Hierbei ist vorgesehen, daß die Diffusions- bzw. Leitungsbahn vollständig innerhalb des aus Halbleitermaterial bestehenden Substrates in einer ausgehend von der Hauptoberfläche des Substrates vorbestimmten Tiefe angeordnet bzw. ausgebildet ist.

Neben einer bezüglich der Hauptoberfläche des Substrates lateralen Anordnung von Fuse- bzw. Anti-Fuse ermöglicht diese Ausführung der Erfindung des weiteren eine vertikale und damit platzsparendere Anordnung von Fuse und Anti-Fuse. Hierbei ist vorgesehen, daß die innerhalb des Substrates ausgebildete Leitungsbahn in ihrer Längserstreckung quer zur Hauptoberfläche des Substrates verläuft.

Das erfindungsgemäße Verfahren zur Herstellung und Aktivierung der oben beschriebenen auftrennbaren Verbindungsbrücke (Fuse) umfaßt folgende Schritte:
- Vorsehen eines aus Halbleitermaterial eines ersten Leitungstyps bestehenden Substrates,
- Ausbilden einer elektrisch leitenden, in Längserstreckung kontinuierlich durchgehenden, quer zur Längserstreckung eine vorbestimmte Breite aufweisenden Leitungsbahn eines zweiten, vom ersten Leitungstyp entgegengesetzten Leitungstyps in dem aus Halbleitermaterial bestehenden Substrat, und
- Erwärmen eines die Leitungsbahn und wenigstens einen Teil des Halbleitermaterials des Substrates umfassenden Aktivierungsabschnittes bis zu einer vorbestimmten Aktivierungstemperatur, die größer ist als die Betriebstemperatur der Verbindungsbrücke, zur irreversiblen Unterbrechung über die gesamte Breite der Leitungsbahn durch Diffusion des Dotierstoffes des Halbleitermaterials des ersten Leitungstyps.

Das erfindungsgemäße Verfahren zur Herstellung und Aktivierung der oben beschriebenen verbindbaren Leitungsunterbrechung (Anti-Fuse) umfaßt folgende Schritte:
- Ausbilden einer elektrisch leitenden Leitungsbahn durch Dotierung mit einem Dotierstoff mit in Längserstreckung eine Lücke mit einem vorbestimmten Abstand bildenden Leitungsbahnstücken eines ersten Leitungstyps in einem aus Halbleitermaterial eines zweiten, vom ersten Leitungstyp entgegengesetzten Leitungstyps bestehenden Substrat, und
- Erwärmen eines die Lücke der Leitungsbahnstücke umfassenden Aktivierungsabschnittes bis zu einer vorbestimmten Aktivierungstemperatur, die größer ist als die Betriebstemperatur der Leitungsunterbrechung, zur irreversiblen Diffusion des Dotierstoffes der Leitungsbahnstücke über die gesamte Lücke der Leitungsbahn.

Bei einer besonders bevorzugten Ausführung des erfindungsgemäßen Verfahrens kann vorgesehen sein, daß zur lokalen Erwärmung des Aktivierungsabschnittes eine Strahlung mit einer vorbestimmten Wellenlänge verwendet wird. Hierbei kann von Vorteil zur lokalen Erwärmung des Aktivierungsabschnittes die Strahlung einer Laserlichtquelle verwendet werden.

Darüber hinaus ist es möglich, daß zur Erwärmung des Aktivierungsabschnittes die durch geeignete Dotierung als Widerstandsbahn ausgebildete Leitungsbahn mit einem Heizstrom beaufschlagt wird. Alternativ hierzu ist es möglich, daß zur Erwärmung des Aktivierungsabschnittes ein in thermischen Kontakt mit der Leitungsbahn stehendes Heizelement verwendet wird.

Weitere Merkmale, Vorteile und Zweckmäßigkeiten der Erfindung ergeben sich aus der Beschreibung von Ausführungsbeispielen anhand der Zeichnung. Es zeigt:
- Figur 1: eine schematische Ansicht einer auftrennbaren Verbindungsbrücke (Fuse) gemäß einem Ausführungsbeispiel der Erfindung;
- Figur 2: eine schematische Draufsicht der Fuse-Anordnung gemäß dem Ausführungsbeispiel nach Figur 1;
- Figur 3: eine schematische Ansicht einer auftrennbaren Verbindungsbrücke (Fuse) gemäß einem weiteren Ausführungsbeispiel der Erfindung;
- Figur 4: eine schematische Draufsicht der Fuse-Anordnung gemäß einem weiteren Ausführungsbeispiel nach Figur 1;
- Figur 5: eine schematische Ansicht einer vertikalen Diffusions-Fuse-Anordnung gemäß einem weiteren Ausführungsbeispiel der Erfindung;
- Figur 6: eine schematische Darstellung einer Diffusions-Anti-Fuse-Anordnung gemäß einem Ausführungsbeispiel der Erfindung;
- Figur 7: eine schematische Draufsicht der Anti-Fuse-Anordnung gemäß dem Ausführungsbeispiel nach Figur 6;
- Figur 8: eine schematische Darstellung einer vertikalen Diffusions-Anti-Fuse-Anordnung gemäß einem weiteren Ausführungsbeispiel der Erfindung;
- Figur 9: eine schematische Draufsicht eines Verdrahtungsfeldes mit Diffusions-Anti-Fuseanordnungen gemäß einem Anwendungs beispiel der Erfindung;
- Figur 10A und 10B: Schaltbilder eines programmierbaren NAND-Gatters und NOR-Gatters mit Diffusions-Anti-Fuseanordnungen gemäß einem weiteren Anwendungs beispiel der Erfindung; und
- Figur 11A und 11B: eine schematische Draufsicht eines Lay-out-Beispieles des Anwendungs beispieles nach den Figuren 10A und 10B.

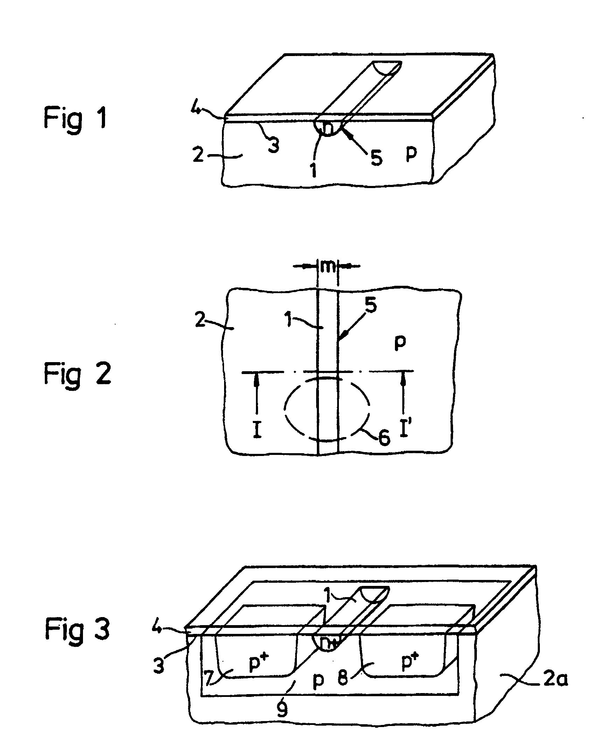

Die Figuren 1 und 2 zeigen die Grundstruktur einer lateralen Diffusions-Fuse-Anordnung gemäß einem Ausführungsbeispiel der Erfindung mit einer niedrig n-dotierten, schmalen flachen Diffusionsbahn mit einer Breite m von etwa 0,5 bis 1 µm, welche von einem großen, p-dotierten Gebiet 2 umgeben ist. Das Gebiet 2 kann das Substrat eines Wafers mit dem Grundmaterial Silizium darstellen, welches durch Grunddotierung mit beispielsweise Bor in einer Konzentration von etwa 3 • 10¹⁵ cm⁻³ bereits vordotiert ist. Die Diffusionsbahn wird durch Implantation von Arsen mit einer Energie von 120 KeV und einer Dosis von etwa 5,0 • 10¹⁴ cm⁻² hergestellt. Hierzu wird in an sich bekannter Weise die Hauptoberfläche 31 des Substrats mit einem Photolack mit einer beispielhaften Dicke von etwa 1,5 µm belackt, vermittels einer geeigneten Maske belichtet und entwickelt. Nach der Implantation wird der Photolack beispielsweise in einer sauerstoffhaltigen Plasmaumgebung entfernt. Der Implantation der Diffusionsbahn schließt sich ein Ausheilschritt bei einer Temperatur von etwa 900° Celsius und einer Dauer von 20 min. an. Anschließend kann auf der Hauptoberfläche 31 eine für Strahlung einer vorbestimmten Wellenlänge transparente oder wenigstens durchscheinende Abdeckschicht 4 abgeschieden werden. Zur Aktivierung der auftrennbaren Verbindungsbrücke bzw. Fuse 5 wird ein durch gestrichelte Linien angedeuteter Aktivierungsabschnitt 6 lokal aufgeheizt, beispielsweise durch kurzzeitige Bestrahlung mit Laserlicht geeigneter Wellenlänge, so daß im Bereich des Aktivierungsabschnittes 6 eine Ineinanderdiffusion von n-Dopanden aus der Diffusionsbahn und p-Dopanden aus dem p-dotierten Gebiet 2 stattfindet. Bei ausreichend hoher Konzentration der p-Dotierung des Gebietes 2 wird der Bereich des Aktivierungsabschnittes 6 hochohmig bzw. umdotiert, was zur Unterbrechung der n-dotierten Diffusionsbahn führt.

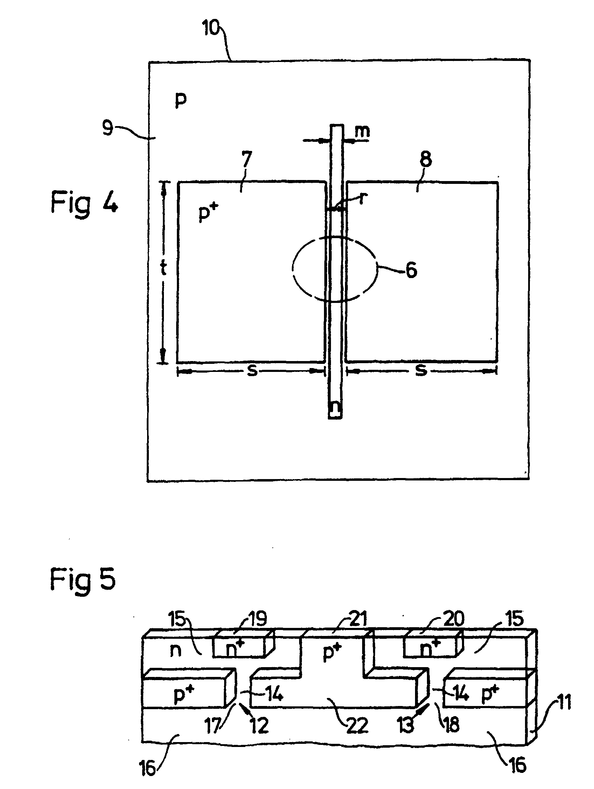

In den Figuren 3 und 4 ist eine Fuse-Anordnung gemäß einem weiteren Ausführungsbeispiel der Erfindung dargestellt. Die Bezugsziffern 1 und 3 bis 6 bezeichnen hierbei dieselben Bestandteile wie bei dem Ausführungsbeispiel nach den Figuren 1 und 2. Zusätzlich sind der Diffusionsbahn zu beiden Seiten in dem aus Halbleitermaterial wie Silizium bestehenden Substrat ausgebildete, p⁺-dotierte Diffusionsbereiche 7, 8 zugeordnet, die durch Implantation von beispielsweise Bor bei einer Energie von 20 KeV und einer Dosis von etwa 5,0 • 10¹⁵ cm⁻² ausgebildet sind, und, bezogen auf die Hauptoberfläche 31 des Substrates, gegenüber der Breite m der Diffusionsbahn größere Abmessungen s, t besitzen können. Die beiden Diffusionsbereiche 7 und 8 sind in einem Abstand r voneinander angeordnet. Folgende Abmessungen können gewählt werden: m = 0,6 µm, r = 1 µm, s = 8 µm, t = 10 µm. Die Diffusionsbereiche 7, 8 sind in einer p-Wanne 9 im Siliziumsubstrat ausgebildet, welche nach Strukturierung mit üblichen Photolithographieprozeßschritten mittels einer Maske 10 und nachfolgender Implantation mit Bor bei einer Energie von etwa 230 KeV und einer Dosis von etwa 1,0 • 10¹³ cm⁻² ausgebildet sein kann.

Figur 5 zeigt ein weiteres Ausführungsbeispiel einer erfindungsgemäßen Fuse-Anordnung 5 mit zwei nebeneinanderliegend innerhalb des Substrates bzw. einer n-Wanne 11 und gegenüber der Hauptoberfläche 31 vertikal ausgebildeten Verbindungsbrücken 12 und 13 mit n-dotierten Diffusionsbahnen 14. Hierbei sind zwei n-dotierte Gebiete 15 und 16 vermittels dünner, vertikal verlaufender n-dotierter Kanäle 17 und 18 miteinander verbunden. Zur Kontaktierung von der Hauptoberfläche 31 sind zwei n⁺-dotierte und somit niederohmige Kontaktgebiete 19 und 20 vorgesehen, die durch einen geeigneten Photolithographieprozeßschritt und einen geeigneten Implantationsschritt gefertigt werden. Ein weiteres, in der Hauptoberfläche 31 ausgebildetes p⁺-dotiertes Kontaktgebiet 21 erlaubt die Kontaktierung des vollständig innerhalb des Substrates bzw. der n-Wanne 11 angeordneten p⁺-dotierten Diffusionsbereiches 22. Zur Aktivierung der vertikal angeordneten Verbindungsbrücken 12 und 13 eignen sich die bereits bei den lateralen Diffusions-Fuse-Anordnungen beschriebenen Erwärmungsverfahren.

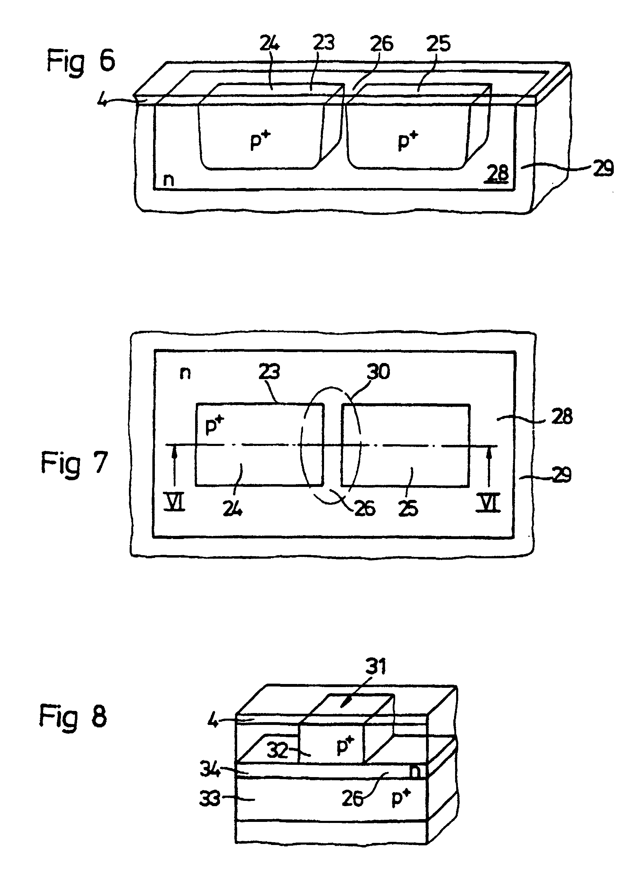

Die Figuren 6 und 7 zeigen in schematischen Ansichten die Grundstruktur einer lateralen Diffusions-Anti-Fuseanordnung gemäß einem weiteren Ausführungsbeispiel der Erfindung. Eine vorzugsweise hoch p⁺-dotierte, breite, tiefe Diffusionsbahn 23 mit zwei Leitungsbahnstücken 24 und 25 mit Breiten von etwa 10 µm und Längen von etwa 15 µm, die in einem Abstand voneinander ausgebildet sind und eine Lücke 26 von etwa 1 bis 1,2 µm bilden, ist von einem großen, niedrig n-dotierten Gebiet 27 umgeben, welche als n-Wanne 28 innerhalb des aus Halbleitermaterial bestehenden Substrates ausgebildet ist. Das Substrat besitzt als Grundmaterial Silizium mit einer p-Typ-Grunddotierung mit Bor von beispielsweise 3 • 10¹⁵ cm⁻³.

Die hierin ausgebildete n-Wanne 28 kann nach Strukturierung mit üblichen Photolithographieprozeßschritten und nachfolgender Implantation mit Phosphor bei einer Energie von etwa 460 KeV und einer Dosis von etwa 6,0 • 10¹² cm⁻² ausgebildet sein, wobei optional eine Anti-Punch-Implantation mit Arsen bei einer Energie von 320 KeV und einer Dosis von etwa 8,0 • 10¹¹ cm⁻² nachgeschaltet sein kann. Die innerhalb der n-Wanne 28 ausgebildeten Leitungsbahnstücke 24 und 25 werden nach Strukturierung mit einem Photolithographieprozeßschritt, bei dem ein Photolack mit einer Dicke von etwa 1,5 µm aufgetragen, vermittels einer geeigneten Maske belichtet, und entwickelt wird, über eine nachfolgende Implantation mit Bor bei einer Energie von etwa 20 KeV und einer Dosis von etwa 5,0 • 10¹⁵ cm⁻² gefertigt. Nach Entfernen der Photolackmaske durch Strippen in einer sauerstoffhaltigen Plasmaumgebung werden die Leiterbahnstücke 24 und 25 bei einer Temperatur von etwa 900° Celsius und einer Dauer von etwa 20 min ausgeheilt. Die Abmessungen und Dotierungskonzentrationen der Leiterbahnstükke, 24, 25, der Lücke 26, und des umgebenden Diffusionsgebietes 27 sind so gewählt, daß bei einer ausreichend hohen Aktivierungstemperatur, die größer ist als die normale Betriebstemperatur der Leitungsunterbrechung bzw. der sonstigen auf dem Substrat ausgebildeten integrierten Schaltkreise, über den gesamten Abstand der Lücke 26 der Leitungsbahnstücke 24 und 25 eine thermodynamisch irreversible Diffusion der Dotierstoffe der Leitungsbahnstücke 24, 25, 32, 33 erfolgt. Durch lokale Aufheizung des Aktivierungsabschnittes 30 bis zu der vorbestimmten Aktivierungstemperatur, beispielsweise vermittels einen auf den Aktivierungsabschnitt 30 gerichteten Laserstrahl, findet somit eine gegenseitige Ineinanderdiffusion der n- und p-Dopanden statt. Bei ausreichend hoher Konzentration der p⁺-Dotierung wird der Aktivierungsabschnitt 30 und damit die Lücke 26 p-dotiert, was zu einer dauerhaften elektrischen Verbindung der beiden p⁺-dotierten Leitungsbahnstücke 24 und 25 führt. Ebenso wie bei der Fuse-Anordnung ist dieser Vorgang irreversibel; die Anti-Fuse-Anordnung ist ebenso schwer zu kontaktieren. Im Gegensatz zur Fuse-Anordnung gemäß den Figuren 1 bis 5 ist eine direkte Erwärmung durch elektrischen Stromfluß nicht möglich, jedoch sind indirekte Heizverfahren einsetzbar, beispielsweise eine resistive Beheizung durch (in den Figuren nicht näher dargestellte) benachbarte Widerstandsmäander aus Polysilizium.

Figur 8 zeigt ein weiteres Ausführungsbeispiel der Erfindung mit einer vertikal angeordneten Diffusions-Anti-Fuse-Anordnung 31 mit zwei hoch p⁺-dotierten Schichten 32 und 33, welche durch eine dünne n-dotierte Schicht 34 voneinander isoliert sind. Die die beiden Leitungsbahnstücke der Anti-Fuse-Anordnung 31 bildenden p⁺-dotierten Schichten 32 und 33 mit der dazwischen angeordneten, die Lücke 26 zwischen den Leitungsbahnstücken darstellenden n-dotierten Schicht 34 kann mit Implantationsschritten oder Epitaxieschritten hergestellt werden.

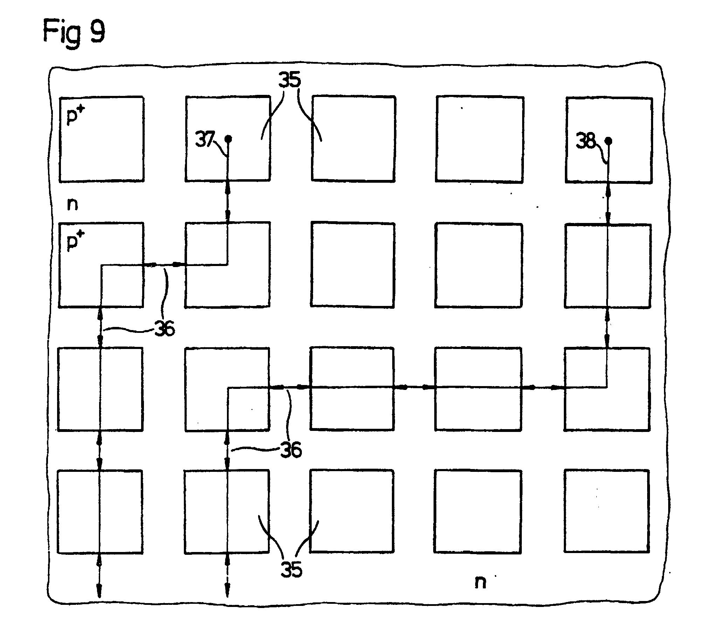

Figur 9 zeigt exemplarisch für die vielfachen Anwendungen der erfindungsgemäßen Fuse- bzw. Anti-Fuseanordnungen ein Verdrahtungsfeld mit einer Vielzahl von integriert ausgebildeten Schaltungsgruppen 35, die durch die lediglich schematisch durch Doppelpfeile dargestellten Diffusions-Anti-Fuses 36 verbindbar sind. Eingezeichnet sind in beispielhafter Form zwei mögliche Verdrahtungswege 37 und 38.

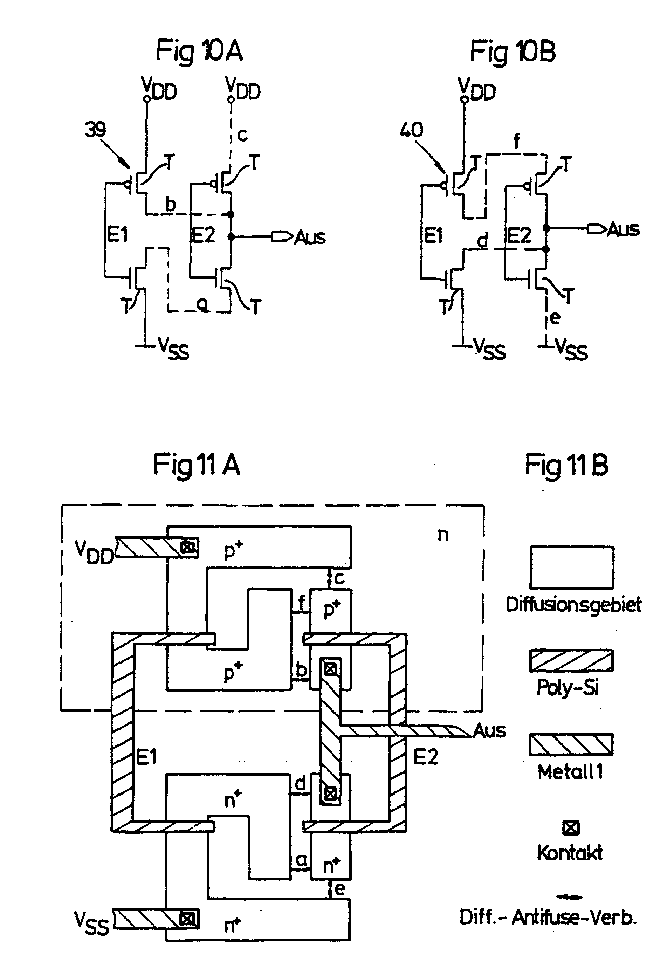

Die Figuren 10A und 10B zeigen ein weiteres bevorzugtes Anwendungsbeispiel in der Form eines programmierbaren NAND-Gatters 39 und eines programmierbaren NOR-Gatters 40 mit schematisch durch gestrichelte Linien dargestellten Diffusions-Anti-Fuseanordnungen a, b, c, d, e, und f. Dieses Ausführungsbeispiel eignet sich insbesondere für nachträgliche Testschaltungsmodifikationen, bei dem durch Aktivierung der Anti-Fuseanordnungen a, b, c bzw. d, e, f und entsprechende Verschaltung der MOS-Transistoren T bzw. Ankopplung an eine Versorgungsspannung V_{DD} und eine Masse V_{SS} eine NAND- bzw. NOR-Funktion mit Eingängen E1, E2 und einem Ausgang Aus realisiert werden kann.

Figur 11A zeigt in schematischer Draufsicht die Layout-Darstellung solcher programmierbaren NAND-NOR-Gatter 39 und 40, wobei in Figur 11B die Symbole der einzelnen Schichten erklärt ist.

## Patentansprüche

1. Auftrennbare Verbindungsbrücke (Fuse) (5,12,13) mit einer in einem aus Halbleitermaterial eines ersten Leitungstyps bestehenden Substrat (2,9) ausgebildeten elektrisch leitenden, in Längserstrekkung kontinuierlich durchgehenden, quer zur Längserstreckung eine vorbestimmte Breite (m) aufweisenden Leitungsbahn (1,14) eines zweiten, vom ersten Leitungstyp entgegengesetzten Leitungstyps, wobei das Halbleitermaterial des ersten Leitungstyps eine ausreichend hohe Dotierkonzentration gegenüber dem Material der Leitungsbahn aufweist, so daß bei einer vorbestimmten Aktivierungstemperatur, die größer ist als die Betriebstemperatur der Verbindungsbrücke, über die gesamte Breite (m) der Leitungsbahn eine Unterbrechung durch Diffusion des Dotierstoffes des Halbleitermaterials des ersten Leitungstyps erfolgt.

2. Verbindungsbrücke nach Anspruch 1, **dadurch gekennzeichnet, daß** der Leitungsbahn ein in dem aus Halbleitermaterial bestehenden Substrat ausgebildeter Diffusionsbereich (7, 8) zugeordnet ist, der durch Dotierung mit einem Dotierstoff des ersten Leitungstyps ausgebildet ist.

3. Verbindungsbrücke nach Anspruch 2, **dadurch gekennzeichnet, daß** der durch Dotierung mit dem Dotierstoff ausgebildete Diffusionsbereich (7, 8) des ersten Leitungstyps zu beiden Seiten der gegenüber den Abmessungen des Diffusionsbereiches (7, 8) eine geringere Breite (m) besitzenden Leitungsbahn des zweiten Leitungstyps ausgebildet ist.

4. Verbindungsbrücke nach Anspruch 2 oder 3, **dadurch gekennzeichnet, daß** die Leitungsbahn des zweiten Leitungstyps durch. Dotierung mit einem Dotierelement ausgebildet ist, dessen Dotierkonzentration betragsmäßig kleiner als die Dotierkonzentration des Dotierstoffes des Diffusionsbereiches (7, 8) des ersten Leitungstyps ist.

5. Verbindungsbrücke nach Anspruch 1 bis 4, **dadurch gekennzeichnet, daß** ein aus einem Teil der Leitungsbahn (1,14) und dem Halbleitermaterial (2,9) und/oder dem Diffusionsbereich (7, 8) bestehender Aktivierungsabschnitt (6) mit einer auf einer Hauptfläche (31) des Substrates ausgebildeten elektrisch isolierenden, für Strahlung einer vorbestimmten Wellenlänge zur lokalen Erwärmung des Aktivierungsabschnittes (6) transparenten oder wenigstens durchscheinenden Abdeckschicht (4) überdeckt ist.

6. Verbindungsbrücke nach Anspruch 1 bis 5, **dadurch gekennzeichnet, daß** die Leitungsbahn (14) des zweiten Leitungstyps vollständig innerhalb des aus Halbleitermaterial bestehenden Substrates in einer ausgehend von der Hauptoberfläche (31) des Substrates vorbestimmten Tiefe angeordnet bzw. ausgebildet ist.

7. Verbindungsbrücke nach Anspruch 6, **dadurch gekennzeichnet, daß** die innerhalb des Substrates ausgebildete Leitungsbahn (14) in ihrer Längserstreckung im wesentlichen quer zur Hauptoberfläche (31) des Substrates verläuft.

8. Verbindungsbrücke nach Anspruch 1 bis 7, **dadurch gekennzeichnet, daß** die Leitungsbahn durch geeignete Dotierung als Widerstandsbahn ausgebildet ist, welche nach Beaufschlagung durch einen elektrischen Strom zur Aktivierung der Verbindungsbrücke erwärmbar ist.

9. Verbindbare Leitungsunterbrechung (Antifuse) mit einer in einem aus Halbleitermaterial bestehenden Substrat ausgebildeten elektrisch leitenden, durch Dotierung mit einem Dotierstoff ausgebildeten Leitungsbahn (23), mit in Längserstreckung eine Lücke (26) mit einem vorbestimmten Abstand bildenden Leitungsbahnstücken (24, 25, 32, 33) eines ersten Leitungstyps und einem wenigstens den Bereich der Lücke (26) der Leitungsbahnstücke (24, 25, 32, 33) ausfüllenden Diffusionsbereich (28,34) eines zweiten, vom ersten Leitungstyp entgegengesetzten Leitungstyps, wobei der Dotierstoff der Leitungsbahnstücke (24, 25, 32, 33) bei vorgegebener Diffusionskonstante bezüglich des Halbleitermaterials des Substrates (29) eine ausreichend hohe Dotierkonzentration aufweist, so daß bei einer vorbestimmten Aktivierungstemperatur, die größer ist als die Betriebstemperatur der Leitungsunterbrechung, über den gesamten Abstand der Lücke (26) der Leiterbahn eine Diffusion des Dotierstoffes der Leitungsbahnstücke (24, 25, 32, 33) erfolgt und zu einer elektrischen Verbindung der beiden Leitungsbahnstücke (24, 25, 32, 33) führt.

10. Leitungsunterbrechung nach Anspruch 9, **dadurch gekennzeichnet, daß** der Diffusionsbereich (28,34) des zweiten Leitungstyps durch Detierung mit einem Dotierelement ausgebildet ist, dessen Dotierkonzentration betragsmäßig kleiner als die Dotierkonzentration des Dotierstoffes der Leitungsbahnstücke (24, 25, 32, 33) des ersten Leitungstyps ist.

11. Leitungsunterbrechung nach Anspruch 10, **dadurch gekennzeichnet, daß** die Leitungsbahnstücke (24, 25, 32, 33) und der Diffusionsbereich (28,34) mit einer auf einer Hauptfläche (31) des Substrates (29) ausgebildeten elektrisch isolierenden, für Strahlung einer vorbestimmten Wellenlänge zur lokalen Erwärmung eines die Lücke umfassenden Aktivierungsabschnittes (30) transparenten oder wenigstens durchscheinenden Abdeckschicht (4) überdeckt ist.

12. Leitungsunterbrechung nach Anspruch 11, **dadurch gekennzeichnet, daß** wenigstens ein Teil der Leitungsbahnstücke (24, 25, 32, 33) innerhalb des aus Halbleitermaterial bestehenden Substrates in einer ausgehend von der Hauptoberfläche (31) des Substrates vorbestimmten Tiefe angeordnet bzw. ausgebildet ist.

13. Leitungsunterbrechung nach Anspruch 12, **dadurch gekennzeichnet, daß** wenigstens der innerhalb des Substrates ausgebildete Teil der Leitungsbahnstücke (24, 25, 32, 33) in seiner Längserstreckung im wesentlichen quer zur Hauptoberfläche (31) des Substrates verläuft.

14. Verbindungsbrücke bzw. Leitungsunterbrechung nach Anspruch 1 bis 13, **dadurch gekennzeichnet, daß** sich die Leitungsbahn (23) in thermischen Kontakt mit einem Heizelement befindet.

15. Verfahren zur Herstellung und Aktivierung einer auftrennbaren Verbindungsbrücke (Fuse) (5,12,13) gemäß Anspruch 1 mit den Schritten:
- Vorsehen eines aus Halbleitermaterial (2,9) eines ersten Leitungstyps bestehenden Substrates,
- Ausbilden einer elektrisch leitenden, in Längserstreckung kontinuierlich durchgehenden, quer zur Längserstreckung eine vorbestimmte Breite (m) aufweisenden Leitungsbahn (1,14) eines zweiten, vom ersten Leitungstyp entgegengesetzten Leitungstyps in dem aus Halbleitermaterial bestehenden Substrat, und
- Erwärmen eines die Leitungsbahn (1,14) und wenigstens einen Teil des Halbleitermaterials des Substrates umfassenden Aktivierungsabschnittes (6) bis zu einer vorbestimmten Aktivierungstemperatur, die größer ist als die Betriebstemperatur der Verbindungsbrücke (5, 12, 13), zur irreversiblen Unterbrechung über die gesamte Breite der Leitungsbahn durch Diffusion des Dotierstoffes des Halbleitermaterials des ersten Leitungstyps.

16. Verfahren nach Anspruch 15, **dadurch gekennzeichnet, daß** zur Erwärmung des Aktivierungsabschnittes (30) die durch geeignete Dotierung als Widerstandsbahn ausgebildete Leitungsbahn mit einem Heizstrom beaufschlagt wird.

17. Verfahren zur Herstellung und Aktivierung einer verbindbaren Leitungsunterbrechung (Antifuse) gemäß Anspruch 9 mit den Schritten:
- Ausbilden einer elektrisch leitenden Leitungsbahn (23) durch Dotierung mit einem Dotierstoff mit in Längserstreckung eine Lücke (26) mit einem vorbestimmten Abstand bildenden Leitungsbahnstücken (24, 25, 32, 33) eines ersten Leitungstyps in einem aus Halbleitermaterial eines zweiten, vom ersten Leitungstyp entgegengesetzten Leitungstyps bestehenden Substrat, und
- Erwärmen eines die Lücke (26) der Leitungsbahnstücke (24, 25, 32, 33) umfassenden Aktivierungsabschnittes (30) bis zu einer vorbestimmten Aktivierungstemperatur, die größer ist als die Betriebstemperatur der Leitungsunterbrechung, zur irreversiblen Diffusion des Dotierstoffes der Leitungsbahnstükke (24, 25, 32, 33) über die gesamte Lücke (26) der Leitungsbahn (23) und zum dauerhaften elektrischen Verbinden der Leitungsbahn stücke.

18. Verfahren nach Anspruch 15 bis 17, **dadurch gekennzeichnet, daß** zur lokalen Erwärmung des Aktivierungsabschnittes (30) eine Strahlung mit einer vorbestimmten Wellenlänge verwendet wird.

19. Verfahren nach Anspruch 18, **dadurch gekennzeichnet, daß** zur lokalen Erwärmung des Aktivierungsabschnittes (30) die Strahlung einer Laserlichtquelle verwendet wird.

20. Verfahren nach Anspruch 15 bis 19, **dadurch gekennzeichnet, daß** zur Erwärmung des Aktivierungsabschnittes (30) ein in thermischen Kontakt mit der Leitungsbahn stehendes Heizelement verwendet wird.

## Claims

1. Fuse (5, 12, 13) having an electrically conductive conduction track (1, 14) formed in a substrate (2, 9) composed of semiconductor material of a first conduction type, which conduction track is fully continuous in its longitudinal extent, has a predetermined width (m) transversely to its longitudinal extent and is of a second conduction type opposite to the first conduction type, the semiconductor material of the first conduction type having a sufficiently high doping concentration compared with the material of the conduction track, so that, at a predetermined activation temperature which is greater than the operating temperature of the fuse, an interruption is effected across the entire width (m) of the conduction track as a result of diffusion of the dopant of the semiconductor material of the first conduction type.

2. Fuse according to Claim 1, **characterized in that** the conduction track is assigned a diffusion region (7, 8) which is formed in the substrate composed of semiconductor material and is formed by doping with a dopant of the first conduction type.

3. Fuse according to Claim 2, **characterized in that** the diffusion region (7, 8) which is formed by doping with the dopant and is of the first conduction type is formed on both sides of the conduction track of the second conduction type, which conduction track has a smaller width (m) compared with the dimensions of the diffusion region (7, 8).

4. Fuse according to Claim 2 or 3, **characterized in that** the conduction track of the second conduction type is formed by doping with a doping element whose doping concentration is less than the doping concentration of the dopant of the diffusion region (7, 8) of the first conduction type.

5. Fuse according to Claims 1 to 4, **characterized in that** an activation section (6), which comprises part of the conduction track (1, 14)and the semiconductor material (2, 9) and/or the diffusion region (7, 8), is covered with an electrically insulating covering layer (4), which is formed on a main surface (31) of the substrate and is transparent or at least translucent to radiation of a predetermined wavelength for local heating of the activation section (6).

6. Fuse according to Claims 1 to 5, **characterized in that** the conduction track (14) of the second conduction type is arranged or formed completely within the substrate composed of semiconductor material at a predetermined depth starting from the main surface (31) of the substrate.

7. Fuse according to Claim 6, **characterized in that** the conduction track (14) formed within the substrate runs, in terms of its longitudinal extent, essentially transversely with respect to the main surface (31) of the substrate.

8. Fuse according to Claims 1 to 7, **characterized in that** the conduction track is designed by means of suitable doping to have the form of a resistive track which can be heated after being loaded by an electric current for the purpose of activating the fuse.

9. Antifuse having an electrically conductive conduction track (23) formed in a substrate composed of semiconductor material, the said conduction track being formed by doping with a dopant and having conduction track segments (24, 25, 32, 33) of a first conduction type which form a gap (26) having a predetermined distance in the longitudinal extent, and having a diffusion region (28, 34) which fills at least the region of the gap (26) of the conduction track segments (24, 25, 32, 33) and is of a second conduction type opposite to the first conduction type, the dopant of the conduction track segments (24, 25, 32, 33) having a sufficiently high doping concentration with a predetermined diffusion constant with regard to the semiconductor material of the substrate (29), so that, at a predetermined activation temperature which is greater than the operating temperature of the antifuse, diffusion of the dopant of the conduction track segments (24, 25, 32, 33) is effected across the entire distance of the gap (26) of the conductor track and leads to an electrical connection of the two conduction track segments (24, 25, 32, 33)

10. Antifuse according to Claim 9, **characterized in that** the diffusion region (28, 34) of the second conduction type is formed by doping with a doping element whose doping concentration is less than the doping concentration of the dopant of the conduction track segments (24, 25, 32, 33) of the first conduction type.

11. Antifuse according to Claim 10, **characterized in that** the conduction track segments (24, 25, 32, 33) and the diffusion region (28, 34) are covered with an electrically 'insulating covering layer (4) which is formed on a main surface (31) of the substrate (29) and is transparent or at least translucent to radiation of a predetermined wavelength for locally heating an activation section (30) which comprises the gap.

12. Antifuse according to Claim 11, **characterized in that** at least part of the conduction track segments (24, 25, 32, 33) is arranged or formed within the substrate composed of semiconductor material at a predetermined depth starting from the main surface (31) of the substrate.

13. Antifuse according to Claim 12, **characterized in that** at least that part of the conduction track segments (24, 25, 32, 33) which is formed within the substrate runs, in terms of its longitudinal extent, essentially transversely with respect to the main surface (31) of the substrate.

14. Fuse and antifuse according to Claims 1 to 13, **characterized in that** the conduction track (23) is in thermal contact with a heating element.

15. Method for the production and activation of a fuse (5, 12, 13) according to Claim 1, having the steps:
- provision of a substrate composed of semiconductor material (2, 9) of a first conduction type,
- formation of an electrically conductive conduction track (1, 14 )which is fully continuous in its longitudinal extent, has a predetermined width (m) transversely with respect to the longitudinal extent and is of a second conduction type opposite to the first conduction type in the substrate composed of semiconductor material, and
- heating of an activation section (6), which comprises the conduction track (1, 14) and at least part of the semiconductor material of the substrate, up to a predetermined activation temperature which is greater than the operating temperature of the fuse (5, 12, 13), for the purpose of irreversible interruption over the entire width of the conduction track as a result of diffusion of the dopant of the semiconductor material of the first conduction type.

16. Method according to Claim 15, **characterized in that** a heating current is applied to the conduction track which is designed by means of suitable doping to have the form of a resistive track, for the purpose of heating the activation section (30).

17. Method for the production and activation of an antifuse according to Claim 9, having the steps:
- formation of an electrically conductive conduction track (23) by doping with a dopant, with conduction track segments (24, 25, 32, 33) of a first conduction type which form a gap (26) having a predetermined distance in the longitudinal extent, in a substrate composed of semiconductor material of a second conduction type opposite to the first conduction type, and
- heating of an activation section (30), which comprises the gap (26) of the conduction track segments (24, 25, 32, 33), up to a predetermined activation temperature which is greater than the operating temperature of the antifuse, for the purpose of irreversible diffusion of the dopant of the conduction track segments (24, 25, 32, 33) across the entire gap (26) of the conduction track (23) and for the purpose of permanent electrical connection of the conduction track segments.

18. Method according to Claims 15 to 17, **characterized in that** radiation having a predetermined wavelength is used for the local heating of the activation section (30).

19. Method according to Claim 18, **characterized in that** the radiation of a laser light source is used for the local heating of the activation section (30).

20. Method according to Claims 15 to 19, **characterized in that** a heating element in thermal contact with the conduction track is used for the heating of the activation section (30).

## Revendications

1. Pont de liaison (fuse) (5, 12, 13) pouvant être séparé et comprenant, formé dans un substrat (2, 9) en un matériau semi-conducteur d'un premier type de conductivité, une piste (1, 14) conductrice de l'électricité s'étendant continûment dans la direction longitudinale et ayant une largeur (m) déterminée à l'avance transversalement à la direction longitudinale d'un deuxième type de conductivité opposé au premier type de conductivité, le matériau semi-conducteur du premier type de conductivité ayant une concentration suffisamment grande par rapport au matériau de la piste conductrice, de sorte que, pour une température d'activation donnée à l'avance qui est supérieure à la température de fonctionnement du pont de connexion, il s'effectue, sur toute la largeur (m) de la piste conductrice, une interruption par diffusion de la substance de dopage du matériau semi-conducteur du premier type de conductivité.

2. Pont de connexion suivant la revendication 1, **caractérisé en ce qu'**il est associé à la piste conductrice une partie (7, 8) de diffusion constituée dans le substrat en le matériau semi-conducteur et formée par dopage par une substance de dopage du premier type de conductivité.

3. Pont de connexion suivant la revendication 2, **caractérisé en ce que** la partie (7, 8) de diffusion, formée par dopage par la substance de dopage du premier type de conductivité, est formée des deux côtés de la piste conductrice du deuxième type de conductivité ayant, par rapport aux dimensions de la partie (7, 8) de diffusion, une largeur (m) qui est plus petite.

4. Pont de connexion suivant la revendication 2 ou 3, **caractérisé en ce que** la piste conductrice du deuxième type de conductivité est formée par dopage par l'élément de dopage dont la concentration de dopage est plus petite en valeur absolue que la concentration de dopage de la substance de dopage de la partie (7, 8) de diffusion du premier type de conductivité.

5. Pont de connexion suivant les revendications 1 à 4, **caractérisé en ce qu'**une partie (6) d'activation, constituée d'une partie de la piste (1, 14) conductrice et du matériau (2, 9) semi-conducteur et/ou de la partie (7, 8) de diffusion, est revêtue d'une couche (4) de revêtement constituée sur une face (31) principale du substrat isolante électriquement et transparente ou au moins perméable à un rayonnement d'une longueur d'onde déterminée à l'avance destinée à réchauffer localement la partie (16) d'activation.

6. Pont de connexion suivant la revendication 1 à 5, **caractérisé en ce que** la piste (14) conductrice du deuxième type de conductivité est disposée ou est constituée entièrement au sein du substrat en le matériau semi-conducteur à une profondeur déterminée à l'avance en partant de la face (31) principale du substrat.

7. Pont de connexion suivant la revendication 6, **caractérisé en ce que** la piste (14) conductrice constituée au sein du substrat s'étend dans son étendue longitudinale sensiblement transversalement à la face (31) principale du substrat.

8. Pont de connexion suivant la revendication 1 à 7, **caractérisé en ce que** la piste conductrice est constituée par un dopage approprié sous la forme d'une piste résistante qui, après alimentation par un courant électrique, peut être réchauffée pour l'activation du pont de connexion.

9. Fusible pouvant être connecté (antifuse) comprenant une piste (23) conductrice constituée dans un substrat en un matériau semi-conducteur conducteur de l'électricité formé par un dopage par une substance de dopage ayant des tronçons (24, 25, 32, 33) d'un premier type de conductivité formant, dans l'étendue longitudinale, un intervalle (26) à une distance donnée à l'avance et une partie (28, 34) de diffusion d'un deuxième type de conductivité opposé au premier, comblant au moins la partie de l'intervalle (26) des tronçons (24, 25, 32, 33) de la piste conductrice, la substance de dopage des tronçons (24, 25, 32, 33) de piste conductrice ayant, pour une constante de diffusion donnée à l'avance par rapport au matériau semi-conducteur du substrat (29), une concentration de dopage suffisamment grande de sorte que, pour une température d'activation donnée à l'avance qui est supérieure à la température de fonctionnement du fusible, il s'effectue sur toute la distance de l'intervalle (26) de la piste conductrice une diffusion de la substance de dopage des tronçons (24, 25, 32, 33) de la piste conductrice et il se produit une connexion électrique des deux tronçons (24, 25, 32, 33) de la piste conductrice.

10. Fusible suivant la revendication 9, **caractérisé en ce que** la partie (28, 34) de diffusion du deuxième type de conductivité est constituée par dopage par un élément de dopage dont la concentration de dopage est plus petite en valeur absolue que la concentration de dopage de la substance de dopage du tronçon (24, 25, 32, 33) de la piste conductrice du premier type de conductivité.

11. Fusible suivant la revendication 10, **caractérisé en ce que** les tronçons (24, 25, 32, 33) de la piste conductrice et la partie (28, 34) de diffusion sont revêtues d'une couche (4) de recouvrement constituée sur une face (31) principale du substrat (29) isolante électriquement et transparente ou au moins perméable aux rayonnements d'une longueur d'onde donnée à l'avance en vue du réchauffement local de la partie (30) d'activation.

12. Fusible suivant la revendication 11, **caractérisé en ce qu'**au moins une partie des tronçons (24, 25, 32, 33) de la piste conductrice est disposée ou est formée au sein du substrat en le matériau semi-conducteur à une profondeur déterminée à l'avance à partir de la face (31) principale du substrat.

13. Fusible suivant la revendication 12, **caractérisé en ce qu'**au moins la partie des tronçons (24, 25, 32, 33) de la piste conductrice formée au sein du substrat s'étend dans son étendue longitudinale sensiblement transversalement à la face (31) principale du substrat.

14. Pont de connexion suivant les revendications 1 à 13, **caractérisé en ce que** la piste (23) conductrice est en contact thermique avec un élément de chauffage.

15. Procédé de production et d'activation d'un pont (5, 12, 13) de connexion (fuse) qui peut être séparé suivant la revendication 1 comprenant les stades :
- on prévoit un substrat en un matériau (2, 9) semi-conducteur d'un premier type de conductivité.
- on forme une piste (1,14) conductrice qui est conductrice de l'électricité, qui s'étend en continu dans l'étendue longitudinale, qui a, transversalement à l'étendue longitudinale, une largeur (m) donnée à l'avance et qui est d'un deuxième type de conductivité opposé au premier type de conductivité dans le substrat en le matériau semi-conducteur, et
- on chauffe une partie (16) d'activation comprenant la piste (1, 14) semi-conductrice et au moins une partie du matériau semi-conducteur du substrat jusqu'à une température d'activation donnée à l'avance, qui est supérieure à la température de fonctionnement du pont (5, 12, 13) de connexion pour obtenir une interruption irréversible sur toute la largeur de la piste conductrice par diffusion de la substance de dopage du matériau semi-conducteur du premier type de conductivité.

16. Procédé suivant la revendication 15, **caractérisé en ce que**, pour échauffer la partie (30) d'activation, on alimente en un courant de chauffage la piste conductrice constituée en piste résistante par un dopage approprié.

17. Procédé de production et d'activation d'une interruption de conduction pouvant être connectée (antifuse) suivant la revendication 9 comprenant les étapes :
- on forme une piste (23) conductrice de l'électricité par dopage par une substance de dopage ayant des tronçons (24, 25, 32, 33) de piste conductrice d'un premier type de conductivité formant, dans l'étendue longitudinale un intervalle (26) à une distance donnée à l'avance dans un substrat en un matériau semi-conducteur d'un deuxième type de conductivité opposé au premier type de conductivité, et
- on échauffe une partie (30) d'activation comprenant l'intervalle (26) entre les tronçons (24, 25, 32, 33) de la piste conductrice jusqu'à une température d'activation déterminée à l'avance qui est supérieure à la température de fonctionnement de l'interruption de conduction, en vue d'obtenir une diffusion irréversible de la substance de dopage des tronçons (24, 25, 32, 33) de la piste conductrice sur tout l'intervalle (26) de la piste (23) conductrice et de relier électriquement de manière permanente les tronçons de la piste conductrice.

18. Procédé suivant la revendication 15 à 17, **caractérisé en ce que** pour l'échauffement local de la partie (30) d'activation, on utilise un rayonnement d'une longueur d'onde donnée à l'avance.

19. Procédé suivant la revendication 18, **caractérisé en ce que** pour l'échauffement local de la partie (30) d'activation, on utilise la rayonnement d'une source de lumière laser.

20. Procédé suivant les revendications 15 à 16, **caractérisé en ce que** pour l'échauffement de la partie (30) d'activation, on utilise un élément chauffant en contact thermique avec la piste conductrice.
